(19) **Europäisches Patentamt**

**European Patent Office**

**Office européen des brevets**

(11) Veröffentlichungsnummer: **0 301 157 B1**

(12) **EUROPÄISCHE PATENTSCHRIFT**

(45) Veröffentlichungstag der Patentschrift: **05.08.92**

(51) Int. Cl.5: **G03F 7/26**

(21) Anmeldenummer: **88101585.3**

(22) Anmeldetag: **04.02.88**

(54) **Druckplattenverarbeitungsgerät mit einer Einrichtung für die Spülwasserrückgewinnung.**

(30) Priorität: **31.07.87 US 80136**

(43) Veröffentlichungstag der Anmeldung:
**01.02.89 Patentblatt 89/05**

(45) Bekanntmachung des Hinweises auf die
Patenterteilung:
**05.08.92 Patentblatt 92/32**

(84) Benannte Vertragsstaaten:
**DE GB NL**

(56) Entgegenhaltungen:

**PATENT ABSTRACTS OF JAPAN, Band 8, Nr. 157 (P-288)[1594], 20. Juli 1984; & JP-A-59 55 439 (KONISHIROKU SHASHIN KOGYO K.K.) 30-03-1984**

**PATENT ABSTRACTS OF JAPAN, Band 10, Nr. 387 (P-530)[2444], 25. Dezember 1986; & JP-A-61 175 641 (KONISHIROKU PHOTO IND CO. LTD) 07-08-1986**

**PATENT ABSTRACTS OF JAPAN, Band 11, Nr. 252 (P-605)[2699], 15. August 1987; & JP-A-62 58 254 (KONISHIROKU PHOTO IND CO. LTD) 13-03-1987**

(73) Patentinhaber: **HOECHST CELANESE CORPO-RATION
Route 202-206 North
Somerville, N.J. 08876(US)**

(72) Erfinder: **Gillich, Thomas N.
3 Little Brook Road
Whitehouse Station New Jersey 08889(US)**
Erfinder: **Mappin, Carlton D.
15 Halstead Way
Mahway New Jersey 07430(US)**

(74) Vertreter: **Zounek, Nikolai, Dipl.-Ing. et al
c/o KALLE Niederlassung der Hoechst AG
Patentabteilung Postfach 3540
Rheingaustrasse 190 D-6200 Wiesbaden
1(DE)**

EP 0 301 157 B1

## Beschreibung

Die Erfindung betrifft ein Druckplattenverarbeitungsgerät mit einer Einrichtung für die Spülwasserrückgewinnung, einem geschlossenen Gehäuse, das Spülwasser, einen Druckplatteneinlaß und -auslaß und eine Einrichtung zum Aufbringen von Spülwasser auf eine zwischen dem Druckplatteneinlaß und -auslaß befindliche Druckplatte enthält.

Bei dem Druckplattenverarbeitungsgerät handelt es sich um ein Gerät für die Sprühentwicklung lithographischer Druckplatten oder Reinigen, Ätzen und chemisches Bearbeiten von Flachdruckformen.

Bei der Vorbereitung von lithographischen Druckplatten werden lichtempfindliche Überzüge auf einen Träger aufgebracht, bei dem es sich im allgemeinen um ein flexibles, dünnes Metallblech handelt, wodurch eine vorsensibilisierte Druckplatte geschaffen wird. Die Platte wird bildweise durch eine Maske belichtet, wodurch die fotoempfindliche Schicht für einen geeignet gewählten Entwickler, falls er negativ arbeitet, unlöslich wird, und löslich für den Entwickler, wenn die Druckplatte positiv entwickelt wird. Die Wirkung des Entwicklers im Falle einer lithographischen Platte besteht darin, die Nichtbildteile der Plattenbeschichtung vollständig zu entfernen, so daß kein Rückstand der Beschichtung auf dem metallischen Träger verbleibt. Der so entschichtete metallische Träger ist frei von Beschichtung und nimmt an diesen Stellen keine Tinte an. Diese scharfe Unterscheidung zwischen Bild- und Nichtbildflächen auf der Platte ist ausschlaggebend für den Erfolg bei der Vorbereitung der lithographischen Druckplatte. Belichtete lithographische Druckplatten können manuell oder maschinell entwickelt werden. Bei Handentwicklung wird der Entwickler auf die Platte und auf einen weichen Schwamm oder auf ein Kissen gegossen und mit diesem die Oberfläche der Druckplatte so lange gerieben, bis durch Augenscheinnahme feststellbar ist, daß die Nichtbildflächen vollständig entfernt sind. Besondere Sorgfalt muß aufgewendet werden, um jede Beschädigung des Bildes durch übermäßiges Reiben oder durch die Verwendung eines besonders aktiven chemischen Entwicklers zu vermeiden.

Die Nachteile einer manuellen Entwicklung von Offset-Druckplatten sind zahlreich. Der Prozeß läuft langsam ab und ist teuer. Gleichförmigkeit des Druckes beim Aufbringen der Entwicklerlösung zum Entfernen der unerwünschten Beschichtung ist meistens unmöglich zu erzielen, und das Einwirken der Entwicklerlösung ist ungleichmäßig. Daraus resultieren häufig fehlerhafte Drucke infolge der unvollständigen Entwicklung oder Unterentwicklung einer Fläche durch das Aufbringen unterschiedlichen Druckes durch die Handentwicklung, die ihrerseits die Qualität des gewünschten Druckbildes beeinflussen. Das Antrocknen von Entwickler an bestimmten Teilen der Druckplatte, noch bevor er zum Entfernen der unerwünschten Beschichtung eingerieben ist, kann zu einem Rückstand auf der Druckplatte führen. Eine weitere Schwierigkeit bei der manuellen Entwicklung ergibt sich für das Aufbringen der Entwicklerlösung. Die derzeitige Praxis von Entwicklungsleuten besteht darin, eine Entwicklermenge auf einen Entwicklungsschwamm oder ein Entwicklungskissen und auf den Mittelpunkt der Druckplatte aufzugießen, wobei die Menge ausreicht, um die Druckplatte zu bearbeiten, und anschließend wird der Entwicklungsfachmann seinen Schwamm in einem Entwicklungsbehälter mit neuer Entwicklungsflüssigkeit benetzen. Diese Vorgangsweise kann sowohl zu einem hohen Grad von Verunreinigung der Verarbeitungsflüssigkeiten durch die entfernte fotoempfindliche Beschichtung als auch zu einer Veränderung der Chemie der Flüssigkeit infolge von Verdampfung führen, die ihrerseits entweder die Wirksamkeit der Chemie verringert, resultierend in einer unvollständigen Entfernung der nichterwünschten Beschichtung in hochkritischen Flächen von Halbtönen oder in einem Anstieg der Flüssigkeitswirksamkeit, was zu einem chemischen Bildangriff führen kann.

Desweiteren kann die Entwicklung einer zweiseitig zu belichtenden Platte durch Entwicklung einer Seite in einem Abwaschbecken zu einem bestimmten Zeitpunkt und durch Umdrehen der Druckplatte zu einer Beschädigung der zuerst entwickelten Seite durch kontaminierte Materialstücke in dem Abwaschbecken führen, die zurück auf die Bild- oder Nichtbildflächen der zuerst entwickelten Seite gedrückt werden, wenn die zweite Seite entwickelt wird.

Diese Defekte treten beispielsweise so lange nicht in Erscheinung, bis die Druckplatte in eine Druckvorrichtung eingespannt wird und die Kosten für die Druckplattenentwicklung aufgewandt wurden. Diese Probleme werden mit steigender Plattengröße kritischer.

Sind viele Druckplatten zu entwickeln, so wird die maschinelle Druckplattenentwicklung angewandt, bei der die Druckplatte durch mechanisches Aufbringen des Entwicklers entwickelt wird.

Es sind automatische Druckplattenverarbeitungsgeräte verfügbar, welche die mit der herkömmlichen manuellen Entwicklung von Druckplatten verbundenen Schwierigkeiten überwinden. Derartige geschlossene Druckplattenentwicklungsgeräte umfassen eine Empfangsstation für die Aufnahme einer Druckplatte, ein kontinuierliches Transportsystem, eine Entwicklungsstation, in welcher der Entwickler auf beiden Seiten der Druckplatte gleichzeitig und gleichmäßig über die komplette Oberfläche beider Seiten aufgebracht wird, ferner eine Vorwässerungsstation zum Aufweichen der Beschichtung, eine Reib- oder Schruppstation, bestehend aus einer frei schwebenden Anordnung eines Satzes von Reinigungsbürsten und eines Satzes von Schruppkisssen des Velourtyps, von denen eines oberhalb und eines unterhalb der Druckplatte in einer Weise angeordnet ist, die den leichten Eintritt der Druckplatte zwischen den Reinigungsbürsten und den Schruppkissen ermöglicht. Die gesamte Reinigungs- und Schruppanordnung ist desweiteren für eine Hin- und Herbewegung quer über die Oberfläche der Druckplatte ausgelegt, jede Hälfte in eine entgegengesetzte Richtung zu der anderen. Befindet sich keine Druckplatte in dem Entwicklungssystem, so reiben die obere und die untere Reinigungs- und Schrubbanordnungen aneinander. Am Ende der Anordnung sind desweiteren Abquetscheinrichtungen befestigt, die in Kontakt mit den folgenden Transportabquetschrollen stehen, wie nachstehend noch beschrieben werden wird.

Bevor die Druckplatte in die Reinigungs- und Schruppstation, wie voranstehend beschrieben, gelangt, wird der Entwickler auf beide Seiten der Druckplatte in einer Vorwässerungskammer aufgebracht. Während sich die Druckplatte vorwärts durch die Vorwässerungskammer bewegt, wird die Beschichtung auf den Nichtbildflächen aufgeweicht, wodurch die anschließende Reinigungs- und Schruppanordnung in die Lage versetzt wird, wirksam zu reinigen oder alle unerwünschten Beschichtungsteile, selbst in den kleinsten Flächen, zu entfernen. Dadurch wird höchste Bildqualität sichergestellt. Desweiteren wird Entwickler kontinuierlich auf die Druckplatte in dem Reinigungs- und Schruppabschnitt aufgebracht, sowohl durch die Reinigungsbürsten hindurch, als auch zwischen den Schruppkissen. Anschließend gelangen die Druckplatten in eine Spülwasserstufe zum Entfernen des überschüssigen Entwicklers und überschüssiger Nichtbildplattenmaterialien. In einigen bekannten Maschinen wird der Entwickler auf die Druckplatte durch Rohre zugemessen und über Schwämme oder Bürsten gesprüht, die gleichfalls dazu dienen, losgelöste Nichtbildpartikel von dem Plattenträger zu entfernen. In der nächsten Stufe innerhalb des Geräts werden der aufgebrachte Entwickler und die abgelösten Nichtbildbeschichtungsteile von der Druckplatte abgewaschen, üblicherweise mit Wasser, das durch Rohre zugeleitet wird. In einer Endstufe wird die abgewaschene, feuchte Oberfläche mit einer Gummilösung beschichtet und jeder Überschuß dieser Gummilösung entfernt, wonach die Druckplatte fertig für den Druck oder für die Lagerung ist. Die Gummilösung wird der Platte durch Rohre gleichfalls zugemessen.

In einigen Geräten werden diese Verarbeitungslösungen durch Sprühdüsen gepumpt, die auf die Plattenoberfläche gerichtet sind. In Weiterentwicklungen bzw. Verbesserungen der Geräte werden der überlaufende Entwickler und die überlaufende Gummilösung zu Behältern zurückgeleitet, von denen sie dann wieder durch die Sprühdüsen hindurchgepumpt werden.

Im Falle von Entwicklern für bestimmte positiv arbeitende Druckplatten ist eine Rückgewinnung infolge der Belüftung des Entwicklers nicht durchführbar. In diesem Fall kann nur frischer Entwickler auf die Druckplatte aufgebracht werden, um eine unerwünschte Belüftung zu vermeiden.

In bezug auf Entwicklungsgeräte, die in der Graphik Anwendung finden, wird angestrebt, die benötigten Mengen von teuren Entwicklern und Endbearbeitungsprodukten, zum Beispiel Veredelungsprodukten, zu verringern, die Betriebsgeschwindigkeit und die Vollständigkeit der Entwicklung zu erhöhen, die Unterscheidung zwischen Bild- und Nichtbildflächen zu steigern und die Anwendung von weniger agressiven Entwicklern zu ermöglichen und somit eine eventuelle Beschädigung des Bildes zu verringern.

In Geräten für die Verarbeitung von belichteten lithographischen Druckplatten wird die Druckplatte üblicherweise unter Sprühköpfen hindurchtransportiert, durch die Entwicklerlösungen, Wasch- und Endbearbeitungslösungen, wie sie durch den Bedarf der einzelnen Druckplatte festgelegt sind, aufeinanderfolgend verteilt werden. Es sind geeignete Zeitintervalle für das Einwirken jeder Lösung vorgesehen, wobei diese Vorgänge zusätzlich durch weiche, nicht kratzende Bürsten, Schrubbkissen, Quetschwalzen und dergleichen unterstützt werden.

Bekannte Druckplattenverarbeitungsgeräte sind in den US-Patenten 4,239,368; 3,995,343; 3,937,175; 3,738,249; 3,809,105; 3,771,428; 4,081,577 und 4,091,404 beschrieben, die durch die Bezugnahme in die vorliegende Beschreibung mit eingeschlossen werden.

Ein Problem bei den bekannten Druckplattenverarbeitungsgeräten besteht in deren übermäßigem Verbrauch von Spülwasser. In der Tat zeigt die Erfahrung von großen Druckereien, daß die jährlichen Kosten, allein für das Spül- bzw. Waschwasser, das durch das Druckplattenverarbeitungsgerät hindurchgepumpt wird, die Kosten der reinen Geräteausrüstung erheblich übersteigen. Wird Spülwasser nur für den einmaligen Gebrauch eingeleitet, so wird es nach der Einzelanwendung entleert, obwohl es noch eine wesentliche Abwaschfähigkeit für Rückstände besitzt. Aufgrund dieser Fähigkeit besteht in Druckereibetrieben der Wunsch, das Spülwasser in den Druckplattenverarbeitungsmaschinen wiederholt weiter zu nutzen, um so eine größere Wirtschaftlichkeit zu erreichen. Dabei ist jedoch zu beachten, daß, sobald die Nichtbildflächen der photographischen Oberfläche der Druckplatte entfernt sind, sie weggeschwemmt werden und das Wasser kontaminieren. Druckplattenverarbeitungsgeräte besitzen häufig Filter, welche die abgelösten Beschichtungsteilchen entfernen, um einen neuerlichen Niederschlag dieser Beschichtungsflocken auf der Platte zu verhindern. Ein derartiges Verarbeitungsgerät ist in dem US-Patent 4,239,368 beschrieben. Im Laufe der Zeit wird jedoch der nicht filterbare Anteil des Spülwassers selbst mit ungefilterten Komponenten verunreinigt. Diese sind typischerweise alkalische Beschichtungskomponenten, welche zu einem unerwünschten Anstieg des pH-Werts der Lösung führen. In solch einem Fall wird die Lösung entweder ausgeschieden oder nach periodischer Überwachung des pH-Werts durch einen Drucker eine Frischwassermenge hinzugefügt. Jedoch bedeutet diese Vorgangsweise nur ein kurzfristiges In-Ordnung-bringen des Problems, da die Lösung im übrigen nicht kontinuierlich ierlich überwacht wird und das Hinzufügen von neutralisierenden Säuren den pH-Wert neutral zwar wiederherstellen kann, jedoch die Leitfähigkeit der Lösung in solch einem Umfang ansteigen läßt, daß das Spülwasser sehr schnell unbrauchbar wird.

In dem Dokument 'Patent Abstracts of Japan', Vol. 8, No. 157, S. 288 (1594), 20. Juli 1984, betreffend die JP-A - 59/55439 ist ein Druckplattenverarbeitungsgerät gezeigt und beschrieben, bei dem zur Reduzierung des Spülwasserverbrauchs und folglich der Wasserkosten das Spülwasser nach dem Waschvorgang aus einem Wasserbehälter des Druckplattenverarbeitungsgeräts in einen Spülwassertank geführt wird, in welchem das Spülwasser behandelt wird. Die Wasserhärte des Spülwassers wird unter 100 durch Ionenaustauschbehandlung gehalten. In diesem Druckplattenverarbeitungsgerät wird weder der pH-Wert noch die elektrische Leitfähigkeit des Spülwassers gemessen und geregelt.

In dem Dokument 'Patent Abstracts of Japan', Vol,. 10, No. 387, S. 530 (2444), 25. Dezember 1986, betreffend die japanische Offenlegungsschrift JP-A - 61/175641 ist eine Druckplattenverarbeitungsanlage beschrieben, bei der die Verarbeitungsbäder mit Spülwasser und einer Behandlungsflüssigkeit gefüllt sind. In dem Behälter mit der Behandlungsflüssigkeit befindet sich ein Detektor, mit dem entweder die elektrische Leitfähigkeit oder der pH-Wert der Behandlungsflüssigkeit gemessen wird. Eine Messung der Leitfähigkeit und des pH-Wertes des Spülwassers ist nicht vorgesehen.

Aufgabe der Erfindung ist es, ein Druckplattenverarbeitungsgerät für lithographische Druckplatten der eingangs beschriebenen Art so zu verbessern, daß der pH-Wert und die Leitfähigkeit des Spülwassers kontinuierlich gemessen werden und eine den pH-Wert einstellende Lösung automatisch im benötigten Umfang hinzugefügt und die Leitfähigkeit des Spülwassers innerhalb eines akzeptablen Arbeitsbereiches gehalten wird.

Diese Aufgabe wird erfindungsgemäß dadurch gelöst, daß außerhalb des Druckplattenverarbeitungsgeräts ein Spülwasserbehälter vorhanden ist, mit einer Pumpe, die Spülwasser aus dem Spülwasserbehälter zu der Spülwasseraufbringungseinrichtung des Druckplattenverarbeitungsgeräts pumpt, daß ein Ablauf das Spülwasser von der Spülwasseraufbringungseinrichtung sammelt und in den Spülwasserbehälter zurückführt, daß ein pH-Meßgerät elektrisch mit einem pH-Meßfühler verbunden ist, der in dem Spülwasserbehälter innerhalb des Spülwasservorrats angeordnet ist, daß eine Einspritzeinrichtung über eine elektrische Leitung mit dem pH-Meßgerät verbunden ist und auf den gemessenen pH-Wert anspricht und daß ein Leitfähigkeitsmeßgerät mit einem Leitfähigkeitsmeßfühler elektrisch verbunden ist, der in dem Spülwasserbehälter innerhalb des Spülwasservorrats angeordnet ist.

Die weitere Ausgestaltung des Druckplattenverarbeitungsgeräts ergibt sich aus den Merkmalen der Patentansprüche 2 bis 5.

Die Erfindung betrifft desweiteren ein Verfahren zum Verlängern der Standzeit des in einem Druckplattenverarbeitungsgerät gemäß dem Anspruch 1 verwendeten Spülwassers in der Weise, daß Spülwasser von einem Spülwasserbehälter außerhalb des Druckplattenverarbeitungsgeräts zu dem Druckplattenverarbeitungsgerät gepumpt, von dem Druckplattenverarbeitungsgerät das Spülwasser gesammelt und dem Spülwasserbehälter zugeleitet wird, daß automatisch und kontinuierlich der pH-Wert und die elektrische Leitfähigkeit des Spülwassers im Spülwasserbehälter gemessen werden, daß automatisch eine den pH-Wert einstellende Verbindung in das Spülwasser im Spülwasserbehälter eingeleitet wird, um den pH-Wert des Spülwassers in einem vorgegebenen Bereich zu halten und daß automatisch eine die Leitfähigkeit einstellende Verbindung in das Spülwasser eingespritzt und die Leitfähigkeit des Spülwasser in einem vorgegebenen Bereich gehalten wird.

Die weiteren Verfahrensschritte der Erfindung ergeben sich aus den Merkmalen der Patentansprüche 7 bis 15.

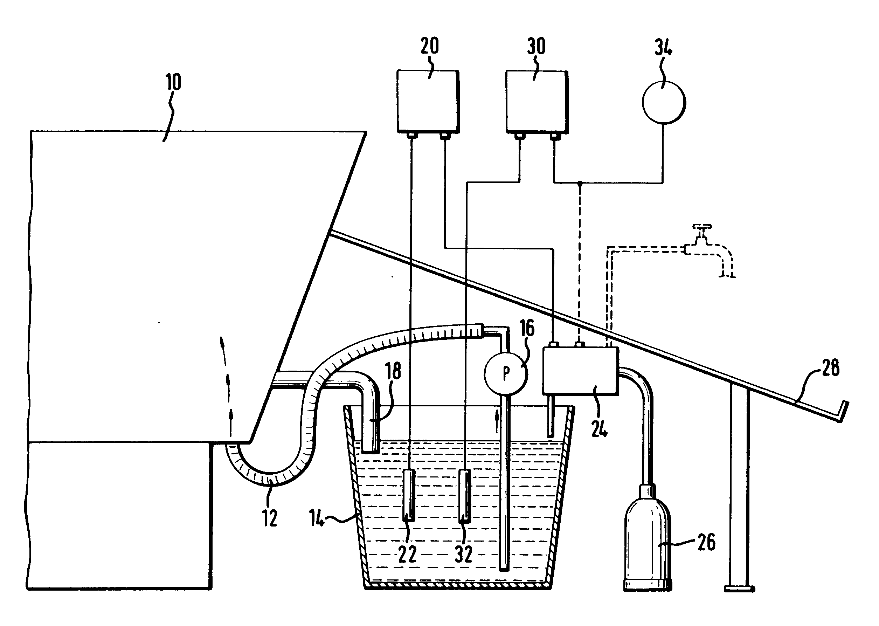

Im folgenden wird die Erfindung anhand der einzigen Zeichnung näher beschrieben.

Ein Druckplattenverarbeitungsgerät 10 weist einen Eingangsschlauch 12 für Spülwasser auf, der mit einem äußeren Spülwasserbehälter 14 anstatt mit einem Frischwasseranschluß verbunden ist. Der Spülwasserbehälter 14 faßt beispielsweise 150 bis 210 Liter Wasser. Der Schlauch 12 ist an eine Pumpe 16 im Inneren des Spülwasserbehälters 14 angeschlossen. Im Betrieb pumpt die Pumpe 16 Wasser aus dem Spülwasserbehälter 14 zu der Spülwasserstufe des Druckplattenverarbeitungsgeräts 10. Gebrauchtes Spülwasser wird von dem Druckplattenverarbeitungsgerät 10 über einen Ablauf 18 in den Spülwasserbehälter 14 zurückgeleitet. Ein pH-Meßgerät 20 überwacht kontinuierlich den pH-Wert des Spül- bzw. Reinigungswassers mittels eines pH-Meßfühlers 22, der im Spülwasserbehälter 14 angeordnet ist. Das pH-Meßgerät liefert eine kontinuierliche Überwachung des pH-Werts des Wassers, und sobald der pH-Wert einen bestimmten vorgegebenen Wert erreicht, sendet das pH-Meßgerät 20 Signale an eine Einspritzeinrichtung 24, die dann eine den pH-Wert einstellende Verbindung, wie beispielsweise eine Säure, von einem Behälter 26 in den Spülwasserbehälter 14 einleitet. Das pH-Meßgerät 20 ist über eine elektrische Leitung mit der Einspritzeinrichtung 24 verbunden. Wird der pH-Wert zu hoch infolge von Spülrückständen auf der Druckplatte, so wird eine kleine Menge von Zitronensäure eingeleitet, um das Spülwasser im Spülwasserbehälter 14 zu neutralisieren. Ein bevorzugter pH-Bereich erstreckt sich von 6,5 bis 7,5, insbesondere von 6,8 bis 7,2, wobei der bevorzugte pH-Wert bei 7,0 liegt. Die Einspritzeinrichtung 24 umfaßt ein Magnetventil und eine Pumpe, die beide nicht gezeigt sind, da es sich um dem Fachmann wohlbekannte Bauteile handelt. Die vollständig bearbeiteten Druckplatten treten aus dem Druckplattenverarbeitungsgerät 10 durch einen Austrittsschlitz aus und werden auf einem schrägen Austrittsgleitblech 28 abgelegt.

Bei dem Druckplattenverarbeitungsgerät 10 wird kontinuierlich und automatisch die Leitfähigkeit des Spülwassers mittels eines Leitfähigkeitsmeßgeräts 30 gemessen. Das Leitfähigkeitsmeßgerät 30 ist mit einem Leitfähigkeitsmeßfühler 32 verbunden, der innerhalb des Spülwasserbehälters 14 angeordnet ist. Wird als Spülwasser zunächst frisches Leitungswasser verwendet, um den Spülwasserbehälter 14 aufzufüllen, so hat das frische Leitungswasser im allgemeinen eine elektrische Leitfähigkeit zwischen 100 und 150 SIEMENS (mhos). Wenn während des Betriebs Druckplatten gespült und Säure hinzugefügt wird, um die Alkalität zu neutralisieren, werden dem System ionisierte Teile hinzugefügt, und die Leitfähigkeit wird graduell ansteigen. Steigt die Leitfähigkeit auf einen nachteilig hohen Leitfähigkeitswert an, so wird dies durch eine Alarmeinrichtung 34 angezeigt, woraufhin das Spülwasser vollständig gegen frisches Spülwasser ausgetauscht werden soll. Die Leitfähigkeit kann zusätzlich durch Hinzusetzen von frischem Leitungswasser abgesenkt werden, indem die Einspritzeinrichtung 24, die über eine elektrische Leitung mit dem Leitfähigkeitsmeßgerät 30 verbunden ist, auf die gemessene Leitfähigkeit anspricht und Frischwasser in den Spülwasserbehälter 14 einleitet, sobald ein vorgebener Leitfähigkeitswert erreicht bzw. überschritten wird. In der Figur ist der Frischwasseranschluß zu der Einspritzeinrichtung 24 und die elektrische Leitung von dem Verzweigungspunkt der Alarmeinrichtung 34 bis zu der Einspritzeinrichtung 24 gestrichelt eingezeichnet, um anzudeuten, daß es sich um zusätzliche Maßnahmen handelt, die nicht bei jedem Gerät realisiert sein müssen. Die Einleitung zusätzlichen Frischwassers stellt nur eine zeitweise Lösung des Problems dar. Die wirtschaftlich beste Vorgangsweise besteht darin, das Spülwasser vollständig auszutauschen, wenn dessen Leitfähigkeit einen Wert zwischen 5000 bis 8000 SIEMENS überschreitet.

Das Leitfähigkeitsmeßgerät 30 und das pH-Meßgerät 20 sind außerhalb des Druckplattenverarbeitungsgeräts 10 angeordnet, können aber auch in dieses integriert werden.

**Patentansprüche**

1.  Druckplattenverarbeitungsgerät mit einer Einrichtung für die Spülwasserrückgewinnung, einem geschlossenen Gehäuse, das Spülwasser, einen Druckplatteneinlaß und -auslaß und eine Einrichtung zum Aufbringen von Spülwasser auf eine zwischen dem Druckplatteneinlaß und -auslaß befindliche Druckplatte enthält, dadurch gekennzeichnet, daß außerhalb des Druckplattenverarbeitungsgeräts (10) ein Spülwasserbehälter (14) vorhanden ist, mit einer Pumpe (16), die Spülwasser aus dem Spülwasserbehälter (14) zu der Spülwasseraufbringungseinrichtung des Druckplattenverarbeitungsgeräts (10) pumpt, daß ein Ablauf (18) das Spülwasser von der Spülwasseraufbringungseinrichtung sammelt und in den Spülwasserbehälter (14) zurückführt, daß ein pHMeßgerät (20) elektrisch mit einem pH-Meßfüler (22) verbunden ist, der in dem Spülwasserbehälter (14) innerhalb des Spülwasservorrats angeordnet ist, daß eine Einspritzeinrichtung (24) über eine elektrische Leitung mit dem pH-Meßgerät (20) verbunden ist und auf den gemessenen pH-Wert anspricht und daß ein Leitfähigkeitsmeßgerät (30) mit einem Leitfähigkeitsmeßfühler (32) elektrisch verbunden ist, der in dem Spülwasserbehälter (14) innerhalb des Spülwasservorrats angeordnet ist.

2.  Druckplattenverarbeitungsgerät nach Anspruch 1, dadurch gekennzeichnet, daß die Einspritzeinrichtung (24) über eine elektrische Leitung mit dem Leitfähigkeitsmeßgerät (30) verbunden ist und auf die gemessene Leitfähigkeit anspricht, um automatisch ein die Leitfähigkeit einstellendes Mittel in den Spülwasserbehälter (14) so lange einzuleiten, bis ein vorgegebener Leitfähigkeitswert sich einstellt.

3. Druckplattenverarbeitungsgerät nach Anspruch 2, dadurch gekennzeichnet, daß eine Alarmeinrichtung (34) das Auftreten eines vorgegebenen Leitfähigkeitswertes im Spülwasser anzeigt.

4. Druckplattenverarbeitungsgerät nach Anspruch 1, dadurch gekennzeichnet, daß es eine Naßreinigungseinrichtung für die Druckplatten enthält.

5. Druckplattenverarbeitungsgerät nach Anspruch 1, dadurch gekennzeichnet, daß es eine Druckplattentransporteinrichtung enthält.

6. Verfahren zum Verlängern der Standzeit des in einem Druckplattenverarbeiungsgerät gemäß Anspruch 1 verwendeten Spülwassers, dadurch gekennzeichnet, daß Spülwasser von einem Spülwasserbehälter außerhalb des Druckplattenverarbeitungsgeräts zu dem Druckplattenverarbeitungsgerät gepumpt, von dem Druckplattenverarbeitungsgerät das Spülwasser gesammelt und dem Spülwasserbehälter zugeleitet wird, daß automatisch und kontinuierlich der pH-Wert und die elektrische Leitfähigkeit des Spülwassers im Spülwasserbehälter gemessen werden, daß automatisch eine den pH-Wert einstellende Verbindung in das Spülwasser im Spülwasserbehälter eingeleitet wird, um den pH-Wert des Spülwassers in einem vorgegebenen Bereich zu halten und daß automatisch eine die Leitfähigkeit einstellende Verbindung in das Spülwasser eingespritzt und die Leitfähigkeit des Spülwassers in einem vorgegebenen Bereich gehalten wird.

7. Verfahren nach Anspruch 6, dadurch gekennzeichnet, daß der Bereich des pH-Werts von 6,5 bis 7,5 reicht.

8. Verfahren nach Anspruch 6, dadurch gekennzeichnet, daß sich der Bereich des pH-Wertes von 6,8 bis 7,2 erstreckt.

9. Verfahren nach Anspruch 6, dadurch gekennzeichnet, daß die den pH-Wert einstellende Verbindung aus einer Säure besteht.

10. Verfahren nach Anspruch 9, dadurch gekennzeichnet, daß die den pH-Wert einstellende Verbindung Zitronensäure ist.

11. Verfahren nach Anspruch 6, dadurch gekennzeichnet, daß der Zustand des Spülwassers durch das Erreichen einer vorgegebenen Leitfähigkeit signalisiert wird.

12. Verfahren nach Anspruch 6, dadurch gekennzeichnet, daß sich der Leitfähigkeitsbereich von 5000 bis 8000 SIEMENS erstreckt.

13. Verfahren nach Anspruch 6, dadurch gekennzeichnet, daß die die Leitfähigkeit einstellende Verbindung aus Wasser besteht.

14. Verfahren nach Anspruch 11, dadurch gekennzeichnet, daß das Spülwasser nach dem Signalisieren einer vorgegebenen Leitfähigkeit ausgewechselt wird.

15. Verfahren nach Anspruch 6 oder 11, dadurch gekennzeichnet, daß das Auswechseln des Spülwassers nach dem Überschreiten der Leitfähigkeit von 5000 SIEMENS beginnt.

## Claims

1. A printing plate processor with a wash water reclamation system which comprises an enclosed housing comprising wash water, a printing plate inlet and a plate outlet and means for applying wash water to a printing plate between said inlet and said outlet, characterized in that a wash water reservoir (14) is provided external to said printing plate processor (10), said reservoir comprising a pump (16) for pumping wash water from the wash water reservoir (14) to the wash water applying means of the printing plate processor (10); that a drain (18) collects the wash water from the wash water applying means and returns it to the reservoir (14); that a pH meter (20) is electrically connected to a pH probe (22) provided in said wash water reservoir (14) within the wash water supply; that an injection system (24) is connected to said pH meter (20) via an electrical line and is responsive to the measured pH; and that a conductivity meter (30) is electrically connected to a conductivity probe (32) located in said wash water reservoir (14) within the wash water supply.

2. The printing plate processor as claimed in claim 1, characterized in that the injection system (24) is connected to the conductivity meter (30) via an electric line and is responsive to the measured conductivity, such that a conductivity adjusting composition is automatically added to the wash water reservoir (14) until a predetermined conductivity is reached.

3. The printing plate processor as claimed in claim 2, characterized in that an alarm means (34) signals when the conductivity in the wash water reaches a predetermined level.

4. The printing plate processor as claimed in claim 1, characterized in that a wet cleansing means for the printing plates is provided.

5. The printing plate processor as claimed in claim 1, characterized in that a transport means for the printing plates is provided.

6. A method of extending the useful lifetime of the wash water used in a printing plate processor as claimed in claim 1, characterized in that wash water is pumped to the printing plate processor from a wash water reservoir external to said printing plate processor; that the used water from the printing plate processor is collected and returned to the wash water reservoir; that the pH and the electroconductivity of the wash water in the wash water reservoir are measured automatically and continuously; that a pH adjusting composition is automatically injected into the wash water in the wash water reservoir in order to maintain the pH of the wash water within a predetermined range; and that a conductivity adjusting composition is automatically injected into the wash water in order to maintain the conductivity of the wash water within a predetermined range.

7. The method of claim 6, characterized in that said pH range extends from 6.5 to 7.5.

8. The method of claim 6, characterized in that said pH range extends from 6.8 to 7.2.

9. The method of claim 6, characterized in that said pH adjusting composition comprises an acid.

10. The method of claim 9, characterized in that said pH adjusting composition comprises citric acid.

11. The method of claim 6, characterized in that the condition of the wash water is signalled upon reaching a conductivity of a predetermined value.

12. The method of claim 6, characterized in that said conductivity range extends from about 5,000 to about 8,000 SIEMENS.

13. The method of claim 6, characterized in that said conductivity adjusting composition comprises water.

14. The method of claim 11, characterized in that the wash water is discarded after the signalling of a predetermined conductivity.

15. The method of claim 6 or 11, characterized in that said discarding of the wash water is performed after the water conductivity exceeds about 5,000 SIEMENS.

**Revendications**

1. Appareil de traitement de plaques d'impression, comprenant un dispositif de recyclage de l'eau de lavage et un carter fermé qui contient de l'eau de lavage, une entrée et une sortie de plaques d'impression et un dispositif pour épandre de l'eau de lavage sur une plaque d'impression se trouvant entre l'entrée et la sortie de plaques d'impression, **caractérisé** en ce qu'un réservoir d'eau de lavage (14) est présent à l'extérieur de l'appareil de traitement de plaques d'impression (10) et est doté d'une pompe (16) qui pompe de l'eau de lavage du réservoir (14) vers le dispositif d'épandage d'eau de lavage, en ce qu'une conduite d'évacuation (18) recueille l'eau de lavage du dispositif d'épandage et la ramène dans le réservoir d'eau de lavage (14), en ce qu'un appareil de mesure de pH (20) est relié électriquement à un capteur de mesure de pH (22), qui est disposé dans le réservoir d'eau de lavage (14) à l'intérieur de la réserve d'eau de lavage, en ce qu'un dispositif d'injection (24) est relié par une ligne électrique à l'appareil de mesure de pH (20) et réagit au pH mesuré, et en ce qu'un appareil de mesure de conductivité (30) est relié électriquement à un capteur de mesure de conductivité (32), qui est disposé dans le réservoir d'eau de lavage (14) à l'intérieur de la réserve d'eau de lavage.

2. Appareil de traitement de plaques d'impression selon la revendication 1, caractérisé en ce que le dispositif d'injection (24) est relié par une ligne électrique à l'appareil de mesure de conductivité (30) et réagit à la conductivité mesurée pour introduire automatiquement un agent réglant la conductivité dans le réservoir d'eau de lavage (14), jusqu'à ce que s'établisse une valeur allouée de conductivité.

3. Appareil de traitement de plaques d'impression selon la revendication 2, caractérisé en ce qu'un dispositif d'alarme (34) indique l'apparition d'une valeur allouée de conductivité dans l'eau de lavage.

4. Appareil de traitement de plaques d'impression selon la revendication 1, caractérisé en ce qu'il contient un dispositif de nettoyage des plaques d'impression par voie humide.

5. Appareil de traitement de plaques d'impression selon la revendication 1, caractérisé en ce qu'il contient un dispositif de transport des plaques d'impression.

6. Procédé pour allonger la durée de vie utile de l'eau de lavage utilisée dans un appareil de traitement de plaques d'impression selon la revendication 1, **caractérisé** en ce que de l'eau de lavage est pompée d'un réservoir d'eau de lavage disposé à l'extérieur de l'appareil de traitement de plaques d'impression vers cet appareil, est recueillie dans cet appareil et ramenée au réservoir d'eau de lavage, en ce que le pH et la conductivité de l'eau de lavage sont mesurés automatiquement et en continu dans le réservoir d'eau de lavage, en ce qu'un composé réglant le pH est introduit automatiquement dans l'eau de lavage dans le réservoir d'eau de lavage afin de maintenir le pH de l'eau de lavage dans une plage allouée, et en ce qu'un composé réglant la conductivité est introduit automatiquement dans l'eau de lavage et la conductivité de l'eau de lavage est maintenue dans une plage allouée.

7. Procédé selon la revendication 6, caractérisé en ce que la plage de pH s'étend de 6,5 à 7,5.

8. Procédé selon la revendication 6, caractérisé en ce que la plage de pH s'étend de 6,8 à 7,2.

9. Procédé selon la revendication 6, caractérisé en ce que le composé réglant le pH est un acide.

10. Procédé selon la revendication 9, caractérisé en ce que le composé réglant le pH est de l'acide citrique.

11. Procédé selon la revendication 6, caractérisé en ce que l'état de l'eau de lavage est signalé par l'atteinte d'une conductivité allouée.

12. Procédé selon la revendication 6, caractérisé en ce que la plage de conductivité s'étend de 5000 à 8000 SIEMENS.

13. Procédé selon la revendication 6, caractérisé en ce que le composé réglant la conductivité est de l'eau.

14. Procédé selon la revendication 11, caractérisé en ce que l'eau de lavage est renouvelée à la suite de la signalisation d'une conductivité allouée.

15. Procédé selon la revendication 6 ou 11, caractérisé en ce que l'eau de lavage commence à être renouvelée à la suite du dépassement d'une conductivité de 5000 SIEMENS.